# FASCICULE DE BREVET EUROPEEN

(11) **EP 3 105 295 B1**
(45) Date de publication et mention de la délivrance du brevet: **27.03.2019**
(21) Numéro de dépôt: 15707705.8
(22) Date de dépôt: 06.02.2015
(51) Int. Cl.: C09D 153/00, B82Y 30/00, G03F 7/00

(54) **PROCEDE DE CONTROLE DE L'ENERGIE DE SURFACE D'UN SUBSTRAT**
VERFAHREN ZUR STEUERUNG DER OBERFLÄCHENENERGIE EINES SUBSTRATS
METHOD FOR CONTROLLING THE SURFACE ENERGY OF A SUBSTRATE

(30) Priorité: 11.02.2014 FR 1451062
(43) Date de publication de la demande: 21.12.2016
(73) Titulaire: Arkema France, 92700 Colombes (FR)
(72) Inventeur: NAVARRO, Christophe, F-64100 Bayonne (FR); NICOLET, Celia, 64230 Sauvagnon (FR); CHEVALIER, Xavier, F-38100 Grenoble (FR)
(86) Numéro de dépôt international: PCT/FR2015/050285
(87) Numéro de publication internationale: WO 2015/121568

(56) Documents cités:
- US-A1- 2003 059 547
- US-A1- 2010 124 629
- SHENGXIANG JI ET AL: "Preparation of Neutral Wetting Brushes for Block Copolymer Films from Homopolymer Blends", ADVANCED MATERIALS, vol. 20, no. 16, 18 août 2008 (2008-08-18) , pages 3054-3060, XP055145371, ISSN: 0935-9648, DOI: 10.1002/adma.200800048 cité dans la demande

## Description

### [Domaine de l'invention]

La présente invention concerne le domaine la nano-structuration d'un copolymère à blocs et en particulier de la préparation de la surface d'un substrat, afin de permettre la nanostructuration d'un film de copolymère à blocs déposé ultérieurement sur la surface, et de contrôler la génération de motifs et leur orientation dans le film de copolymère à blocs.

Plus particulièrement, l'invention se rapporte à un procédé de contrôle de l'énergie de surface d'un substrat. L'invention se rapporte en outre à une composition utilisée pour la mise en oeuvre de ce procédé et à un procédé de nano-structuration d'un copolymère à blocs.

### [Art antérieur]

Le développement des nanotechnologies a permis de miniaturiser constamment les produits du domaine de la microélectronique et les systèmes micro-électro mécaniques (MEMS) notamment. Aujourd'hui, les techniques de lithographie classiques ne permettent plus de répondre à ces besoins constants de miniaturisation, car elles ne permettent pas de réaliser des structures avec des dimensions inférieures à 60nm.

Il a donc fallu adapter les techniques de lithographie et créer des masques de gravure qui permettent de créer des motifs de plus en plus petits avec une grande résolution. Avec les copolymères à blocs il est possible de structurer l'arrangement des blocs constitutifs des copolymères, par ségrégation de phase entre les blocs formant ainsi des nano-domaines, à des échelles inférieures à 50nm. Du fait de cette capacité à se nano-structurer, l'utilisation des copolymères à blocs dans les domaines de l'électronique ou de l'optoélectronique est maintenant bien connue.

Les copolymères à blocs destinés à former des masques de nano-lithographie doivent cependant présenter des nano-domaines orientés perpendiculairement à la surface du substrat, afin de pouvoir ensuite retirer sélectivement un des blocs du copolymère à blocs et créer un film poreux avec le (ou les) bloc(s) résiduel(s). Les motifs ainsi créés dans le film poreux peuvent être ultérieurement transférés, par gravure, au substrat sous-jacent. Cependant, sans contrôle de l'orientation, les nano-domaines tendent à s'organiser de manière aléatoire. En particulier, lorsque l'un des blocs du copolymère à blocs présente une affinité préférentielle pour la surface sur laquelle il est déposé, les nano-domaines ont alors tendance à s'orienter parallèlement à la surface. C'est pourquoi, la structuration recherchée, c'est-à-dire la génération de domaines perpendiculaires à la surface du substrat, dont les motifs peuvent être cylindriques, lamellaires, hélicoïdaux ou sphériques par exemple, nécessite la préparation du substrat en vue de contrôler son énergie de surface.

Parmi les possibilités connues, on dépose sur le substrat un copolymère statistique dont les monomères peuvent être identiques en tout ou partie à ceux utilisés dans le copolymère à blocs que l'on veut déposer. En outre, si l'on souhaite éviter par exemple la diffusion du copolymère statistique, il est préférable de greffer et /ou réticuler le copolymère sur la surface, par l'utilisation de fonctionnalités adéquates. On entend par greffage la formation d'une liaison par exemple covalente entre le substrat et le copolymère. Par réticulation, on entend la présence de plusieurs liaisons entre les chaines copolymères.

Mansky et al. dans Science, vol 275, pages 1458-1460 (7 mars 1997) ont montré qu'un copolymère statistique de Poly(méthacrylate de méthyle-co-styrène) (PMMA-r-PS), fonctionnalisé par une fonction hydroxyle en bout de chaine, permet un bon greffage du copolymère à la surface d'un substrat de silicium présentant une couche d'oxyde natif (Si/SiO₂ natif). In et al, Langmuir 2006, Vol.22, 7855-7860, ont par ailleurs montré que l'on pouvait avantageusement améliorer le greffage du copolymère statistique sur la surface d'un substrat, et notamment la vitesse de greffage, en introduisant, non plus en bout de chaine, mais réparties aléatoirement au sein même du copolymère statistique, plusieurs fonctions hydroxyle. Dans ce cas, la liaison covalente entre le copolymère et la surface du substrat est créée grâce au greffage des fonctions hydroxyle réparties au sein de la chaine polymère. Le greffage d'un copolymère statistique permet ainsi de supprimer l'affinité préférentielle d'un des blocs du copolymère à blocs pour la surface, et d'éviter l'obtention d'une orientation préférentielle des nano-domaines parallèlement à la surface du substrat. Ces documents décrivent aussi que pour pouvoir obtenir une surface dite « neutre » vis-à-vis du copolymère à blocs lorsqu'il est déposé sur cette surface, afin de favoriser une orientation des nano-domaines perpendiculairement à la surface du substrat, il est nécessaire de contrôler la composition du copolymère statistique et notamment les ratios en co-monomères. En effet, l'énergie de surface, permettant l'obtention d'une orientation des nano-domaines perpendiculairement à la surface et sans défaut, correspond à une composition restreinte du copolymère statistique greffé en termes de ratios de co-monomères. Or, s'il est possible de faire varier la composition d'un copolymère statistique à travers sa synthèse, il s'avère en revanche très difficile de retrouver strictement les mêmes ratios massiques incorporés de chaque co-monomère, rigoureusement contrôlés avant le début de la réaction de polymérisation, ainsi que la masse visée initialement, dans le copolymère synthétisé au final. De plus, la synthèse de copolymères, pouvant être statistiques ou à gradients, est dépendante de la nature chimique des co-monomères, si bien qu'il est parfois impossible de synthétiser un copolymère avec un système de co-monomères donné.

Une autre approche utilisée pour orienter les nano-domaines d'un copolymère à blocs sur une surface consiste à déposer sur la surface du substrat un copolymère statistique réticulable. D.Y. Ryu et al, Science, vol 308, pages 236 - 239 (08 avril 2005) ont démontré que l'utilisation d'un copolymère statistique réticulable sur la surface du substrat permet d'obtenir des films relativement épais (de quelques nm à plusieurs dizaines voire centaines de nm), et sur des substrats où les copolymères statistiques se greffent difficilement, tels que les substrats organiques par exemple. Cependant, avec l'utilisation de copolymères réticulables, une limitation apparait lorsque l'on souhaite neutraliser une surface de topographie donnée. Le dépôt du copolymère statistique suivi de sa réticulation vient complètement couvrir la surface de topographie donnée qui ne peut plus être exploitée en tant que telle, la réticulation empêchant toute élimination d'une partie de la surface non souhaitée couverte, rendant cette surface dite non conforme. Lorsque l'on utilise les copolymères non réticulés il est possible d'enlever le copolymère statistique distant de la surface car non greffé, par exemple par lavage de la surface avec un solvant adéquat. Ainsi, après élimination de l'excès de copolymère, on retrouve la topographie de la surface initiale, dite dans ce cas conforme.

S. Ji et al. Adv. Mater., 2008, Vol. 20, 3054-3060 ont par ailleurs décrit une autre approche pour neutraliser la surface d'un substrat, consistant à déposer sur la surface du substrat, un mélange ternaire d'un copolymère diblocs, de bas poids moléculaire, avec ses deux homopolymères correspondants, de bas poids moléculaire, chaque homopolymère comportant des fonctions chimiques permettant un greffage sur la surface du substrat. La présence du copolymère à blocs dans le mélange ternaire permet d'homogénéiser le mélange des deux homopolymères avant leur greffage sur la surface du substrat et d'éviter ainsi une séparation de phase macroscopique des homopolymères dans le mélange, menant alors à une fonctionnalisation non homogène de la surface. Le mélange, présentant des proportions adéquates dans chacun des constituants, permet de neutraliser la surface par rapport au copolymère à blocs déposé par la suite sur cette surface.

Cependant, il n'est pas toujours facile de trouver directement les bonnes proportions d'homopolymères pour l'obtention d'une surface neutre. De plus, s'il n'y a pas suffisamment de copolymère à blocs dans le mélange, ou si le copolymère n'a pas le bon poids moléculaire, on assiste à une ségrégation de phase macroscopique. Par conséquent, il peut être fastidieux de trouver les bonnes proportions de chacun des constituants du mélange ternaire.

Une autre technique pour contrôler l'énergie de surface d'un substrat dans le cadre de la structuration de copolymères à blocs, consiste à greffer successivement des homopolymères. Cette méthode, décrite par G.Liu et al, J. Vac. Sci. Technol. B27, pages 3038-3042 (2009) et par M.-S. She et al, ACS Nano, Vol.7, N°3, pages 2000 - 2011 (2013), consiste à greffer sur le substrat un premier homopolymère possédant des fonctions hydroxyle, puis à greffer sur cette première couche greffée un deuxième homopolymère possédant des fonctions hydroxyle, chaque homopolymère étant à base d'un des monomères constitutifs du copolymère à blocs auto-assemblé déposé sur la deuxième couche greffée. L'énergie de surface du substrat est contrôlée en ajustant les ratios en homopolymères greffés. Ce contrôle des ratios en homopolymères greffés est notamment réalisé en faisant varier les durées et températures des traitements thermiques nécessaires aux greffages, ainsi que les masses moléculaires des homopolymères.

Cependant, il s'avère que ce procédé est fastidieux à mettre en oeuvre du fait du grand nombre d'étapes à réaliser et des nombreux paramètres expérimentaux à contrôler.

S. Ji &al., Macromolecules, Vol.43, pages 6919 - 6922 (2010) ; E. Han &al., ACS Nano,Vol.6, N°2, pages 1823-1829 (2012) et W. Gu &al., ACS Nano, Vol.6, N°11, pages 10250- 10257 (2012) décrivent encore une autre technique consistant à greffer sur le substrat un copolymère à blocs de faible masse molaire, comportant à l'une ou l'autre de ses extrémités une fonction chimique permettant le greffage, et dont les blocs sont de nature chimique identique aux blocs du copolymère à blocs destiné à être déposé et auto-assemblé sur cette couche greffée. Le copolymère à blocs greffé sur la surface ne présente pas de séparation de phase, car sa masse molaire est trop petite, si bien qu'il permet d'obtenir une couche chimiquement homogène à la surface du substrat.

Cependant, si le degré de polymérisation et/ou le paramètre de ségrégation de phase du copolymère à blocs greffé sont mal maitrisés et deviennent trop importants, la neutralisation de surface est moins efficace car il y a séparation de phase entre les blocs. Par ailleurs, pour permettre un bon greffage de la couche de copolymère à blocs, il est nécessaire que la fonction chimique permettant le greffage du copolymère à blocs soit localisée dans le bloc présentant la plus forte affinité pour la surface.

H. S. Suh &al., Macromolecules, Vol.43, pages 461-466 (2010) ont rapporté l'utilisation d'organosilicates pour neutraliser la surface du substrat. Pour cela, un sol-gel de silicates fonctionnalisés par des composés organiques est déposé sur le substrat, puis réticulé jusqu'à obtenir un dépôt neutre par rapport au copolymère à blocs assemblé par la suite sur ce dépôt. Les conditions pour obtenir une surface neutre avec le sol-gel réticulé dépendent du temps et de la température de réticulation, ainsi que du type de composé organique utilisé pour fonctionnaliser le silicate.

Cependant, il s'avère que ce procédé est limité à l'obtention de surface dite non conforme et est fastidieux à mettre en oeuvre du fait des nombreux paramètres expérimentaux à contrôler.

Enfin, une autre technique, décrite par J. N. L. Albert &al., ACS Nano, Vol.3, N°12, pages 3977-3986 (2009) et J. Xu & al., Adv. Mater., 22, pages 2268-2272 (2010), repose sur la formation de monocouches auto-assemblées, encore dénommées SAM (de l'acronyme anglais «Self-Assembled Monolayer»), qui sont obtenues avec de petites molécules organiques. Une monocouche auto-assemblée SAM est en général obtenue par dépôt en phase vapeur, tel que par exemple une couche de chlorosilane fonctionnalisé sur un substrat de silicium ayant subi un traitement ultraviolet/ozone (UVO), ou bien par trempage du substrat dans une solution contenant la molécule, telle qu'une solution à base de thiols pour neutraliser une surface d'or, ou à base de phosphonates pour neutraliser une couche d'oxyde par exemple. En général la molécule à la base de la monocouche auto-assemblée SAM présente des groupements chimiques dont la nature est proche de la nature chimique des blocs du copolymère à blocs déposé par la suite sur la monocouche, afin d'éviter une affinité préférentielle d'un des blocs du copolymère à blocs pour la surface. Une variante de cette méthode consiste à déposer une monocouche auto-assemblée SAM sur le substrat, la monocouche présentant une affinité pour un des blocs d'un copolymère à blocs donné, puis à venir modifier directement la monocouche SAM, par un traitement UV, ou une oxydation locale par exemple, afin de la rendre neutre vis-à-vis du copolymère à blocs, ou à créer un contraste chimique entre la zone non-modifiée et la zone modifiée qui permettra de diriger par la suite l'orientation du copolymère à blocs.

Ce procédé est cependant complexe à mettre en oeuvre et présente plusieurs inconvénients. Il nécessite de trouver un couple fonction chimique/nature de la surface qui soit approprié. Par conséquent, ce procédé ne peut marcher que pour un jeu restreint de natures de surfaces. La qualité des monocouches SAM est par ailleurs difficile à contrôler, car il peut aussi se former des multicouches. Le procédé nécessite des durées généralement trop longues à l'échelle industrielle, typiquement de quelques heures. Enfin, il n'existe pas de règles pour trouver la nature chimique des petites molécules permettant la neutralisation du substrat et la composition de la SAM ne suit pas forcément la composition de la solution dans le cas d'un mélange de petites molécules.

Les différentes approches décrites ci-dessus permettent de contrôler l'orientation d'un copolymère à blocs sur une surface préalablement traitée. En revanche, ces solutions restent généralement trop fastidieuses et complexes à mettre en oeuvre, coûteuses et/ou nécessitent des temps de traitement trop longs pour être compatibles avec des applications industrielles.

Le document US2003/05947 a trait à une composition de vernis de finition comprenant un polymère acrylique avec une fonction hydroxyle. Une telle composition n'est pas destinée à être utilisée pour la mise en oeuvre d'un procédé de contrôle de l'énergie de surface d'un substrat et elle ne comprend pas un mélange de copolymères comprenant chacun au moins une fonction de greffage ou de réticulation. La composition décrite dans ce document ne permet pas de neutraliser l'énergie de surface du substrat ni d'orienter, selon une direction particulière, les nano-domaines d'un copolymère à blocs déposé ultérieurement sur la surface.

La solution la plus répandue et qui semble être la moins complexe, consistant à greffer sur la surface du substrat un copolymère statistique de composition particulière, permet de contrôler efficacement l'énergie de surface du substrat. Cependant, les difficultés de reproductibilité de synthèse d'un copolymère statistique ou à gradients avec une composition restreinte en termes de ratios de co-monomères et une masse bien définie, limitent l'intérêt de l'utilisation d'un tel copolymère pour neutraliser facilement et rapidement la surface d'un substrat.

La demanderesse s'est donc intéressée à ce problème et a cherché une solution pour pallier l'erreur expérimentale et les déviations sur la composition et la masse du copolymère statistique, tout en limitant le nombre de synthèses nécessaires qui accroissent le coût, afin de réaliser une composition particulière qui permette de contrôler efficacement l'énergie de surface du substrat sur lequel la composition est déposée afin d'y déposer un copolymère à blocs.

### [Problème technique]

L'invention a donc pour but de remédier à au moins un des inconvénients de l'art antérieur. L'invention vise notamment à proposer une solution alternative simple, peu coûteuse et réalisable industriellement, pour pouvoir nano-structurer un copolymère à blocs caractérisé en ce qu'elle comprend les étapes du procédé de contrôle de l'énergie de surface d'un substrat donné, par le greffage et/ou la réticulation d'une composition, tout en minimisant au maximum le nombre de synthèses de cette composition, pour permettre l'obtention d'une orientation particulière des nano-domaines du film de copolymère à blocs déposé ultérieurement sur ladite surface..

### [Brève description de l'invention]

A cet effet, l'invention a pour objet un procédé de nano-structuration d'un copolymère à blocs caractérisé en ce qu'il comprend les étapes d'un procédé de contrôle de l'énergie de surface d'un substrat, permettant l'obtention d'une orientation particulière des nano-domaines du film de copolymère à blocs déposé ultérieurement sur ladite surface, puis une étape de dépôt d'une solution du copolymère à blocs sur la surface dudit substrat préalablement traitée, et une étape de recuit permettant une nano-structuration dudit copolymère à blocs par génération de motifs nano-structurés et orientés selon une direction particulière, ledit procédé de contrôle de l'énergie de surface d'un substrat étant caractérisé en ce qu'il comprend les étapes suivantes :
- préparer un mélange de copolymères, chaque copolymère comprenant au moins une fonction permettant son greffage ou sa réticulation sur la surface dudit substrat,
- déposer ledit mélange ainsi préparé sur la surface dudit substrat,
- procéder à un traitement entraînant le greffage ou la réticulation de chacun des copolymères du mélange sur la surface du substrat.

Ainsi, le procédé selon l'invention permet de maitriser précisément et facilement les ratios de co-monomères du mélange en mélangeant, dans des proportions choisies, des polymères de compositions connues. Les taux de co-monomères sont donc maitrisés simplement et toute erreur expérimentale est évitée. Par ailleurs, ce procédé permet également de mélanger des polymères comprenant chacun des co-monomères non polymérisables directement l'un avec l'autre et donc, de s'affranchir de la nature chimique des co-monomères.

Les co-monomères constitutifs de chacun des polymères du mélange peuvent être au moins en partie différents de ceux présents respectivement dans chacun des blocs du copolymère à blocs déposé ultérieurement sur la surface pour être nano-structuré.

Est également décrite une composition destinée à être utilisée pour la mise en oeuvre du procédé de nano-structuration d'un copolymère à blocs avec contrôle de l'énergie de surface décrit ci-dessus, caractérisée en ce qu'elle comprend un mélange de copolymères, chaque polymère comprenant au moins une fonction permettant son greffage ou sa réticulation sur la surface d'un substrat, de sorte qu'une fois greffée ou réticulée sur la surface dudit substrat ladite composition neutralise l'énergie de surface dudit substrat et permet une orientation particulière des nano-domainesdu copolymère à blocs déposé sur ladite surface.

Enfin, l'invention porte sur une utilisation du procédé de contrôle de l'énergie de surface d'un substrat décrit ci-dessus dans des applications de lithographie.

D'autres particularités et avantages de l'invention apparaitront à la lecture de la description faite à titre d'exemple illustratif et non limitatif, en référence aux Figures annexées qui représentent :
- la Figure 1, un schéma d'un exemple d'installation de polymérisation pouvant être utilisée,
- la Figure 2, des photos prises au microscope électronique à balayage, d'échantillons de copolymères à blocs auto-assemblés sur des surfaces fonctionnalisées avec différentes compositions de copolymères.

### [Description détaillée de l'invention]

Par « polymères » on entend soit un copolymère (de type statistique, à gradient, à blocs, alterné), soit un homopolymère.

Le terme « monomère » tel qu'utilisé se rapporte à une molécule qui peut subir une polymérisation.

Le terme « polymérisation » tel qu'utilisé se rapporte au procédé de transformation d'un monomère ou d'un mélange de monomères en un polymère.

On entend par « copolymère », un polymère regroupant plusieurs unités monomères différentes.

On entend par « copolymère statistique », un copolymère dans lequel la distribution des unités monomères le long de la chaîne suit une loi statistique, par exemple de type Bernoullien (ordre zéro de Markov) ou Markovien du premier ou du second ordre. Lorsque les unités de répétition sont réparties au hasard le long de la chaîne, les polymères ont été formés par un processus de Bernouilli et sont appelés copolymères aléatoires. Le terme copolymère aléatoire est souvent utilisé, même lorsque le processus statistique ayant prévalu lors de la synthèse du copolymère n'est pas connu.

On entend par « copolymère à gradient », un copolymère dans lequel la distribution des unités monomères varie de manière progressive le long des chaines.

On entend par « copolymère alterné », un copolymère comprenant au moins deux entités monomères qui sont distribuées en alternance le long des chaines.

On entend par« copolymère à blocs », un polymère comprenant une ou plusieurs séquences ininterrompues de chacune des espèces polymères distincts, les séquences polymères étant chimiquement différentes l'une de, ou des, autre(s) et étant liées entre elles par une liaison chimique (covalente, ionique, liaison hydrogène, ou de coordination). Ces séquences polymères sont encore dénommées blocs polymères. Ces blocs présentent un paramètre de ségrégation de phase tel que, si le degré de polymérisation de chaque bloc est supérieur à une valeur critique, ils ne sont pas miscibles entre eux et se séparent en nano-domaines. On note que, lorsqu'un tel copolymère à blocs est utilisé comme constituant dans un mélange quelconque réalisé dans le cadre de la présente invention, pour fonctionnaliser un substrat donné, il comportera soit directement insérées dans le segment d'un ou des blocs, soit à une ou plusieurs extrémités, une ou plusieurs fonctions chimiques permettant le greffage du copolymère sur le substrat.

On entend par « homopolymère », un polymère constitué d'une seule entité monomérique donnée. On note que lorsqu'un tel homopolymère est utilisé comme constituant dans un mélange quelconque réalisé dans le cadre de la présente invention, pour fonctionnaliser un substrat donné, il comportera soit dans la chaine de monomères soit à une ou ses extrémités, une ou plusieurs fonctions chimiques permettant le greffage sur un substrat donné.

Le terme « miscibilité » s'entend de la capacité de deux ou plusieurs composés à se mélanger totalement pour former une phase homogène. On peut déterminer le caractère miscible d'un mélange quand la somme des températures de transition vitreuse (Tg) du mélange est inférieure strictement à la somme des Tg des composés pris isolément.

Le principe de l'invention consiste à réaliser une composition apte à permettre un contrôle de l'énergie de surface d'un substrat pour pouvoir nano-structurer un copolymère à blocs, et plus particulièrement générer des motifs (cylindres, lamelles, etc) orientés perpendiculairement à la surface du substrat.

Pour cela, la composition comprend un mélange de polymères, dans lequel chaque polymère comprend au moins une fonction permettant son greffage ou sa réticulation sur la surface du substrat. Les fonctions de greffage, telles que des fonctions hydroxyle par exemple, ou les fonctions de réticulation, telles que des fonctions époxy par exemple, sont présentes en bout de chaine ou dans les chaines de chacun des polymères constitutifs du mélange.

Les polymères constitutifs du mélange peuvent être de nature identique ou différente. Un mélange pourra donc comprendre des copolymères statistiques et/ou à gradient et/ou à blocs et/ou alternés et/ou des homopolymères. Une condition essentielle est que chaque copolymère et/ou homopolymère du mélange, quelle que soit sa nature, comprend au moins une fonction permettant son greffage ou sa réticulation sur la surface du substrat.

Chaque polymère constitutif du mélange a une composition connue et est à base d'un ou plusieurs co-monomères qui peuvent être en tout ou partie différents des co-monomères à base du copolymère à blocs destiné à être déposé et auto-assemblé sur la surface. Plus particulièrement, lorsque le mélange comprend un homopolymère, le monomère à base de l'homopolymère sera identique à l'un des co-monomères constitutifs des autres copolymères du mélange et des co-monomères constitutifs du copolymère à blocs à nanostructurer. Ainsi, chaque copolymère utilisé dans le mélange pourra présenter un nombre variable « x » de co-monomères, avec x prenant des valeurs entières, de préférence x≤7, et de façon encore préférée 2≤x≤5. Les proportions relatives, en unités de monomères, de chaque co-monomère constitutif de chaque copolymère du mélange sont avantageusement comprises entre 1 et 99% par rapport au(x) co-monomère(s) avec le(s)quel(s) il co-polymérise.

La masse moléculaire en nombre de chaque polymère du mélange, mesurée par chromatographie d'exclusion stérique (SEC en anglais) ou chromatographie sur gel perméable (GPC en anglais), est de préférence comprise entre 500 et 250000 g/mol, et de façon encore préférée comprise entre 1000 et 150000 g/mol.

La polydispersité de chaque polymère du mélange, qui est le rapport des masses moléculaires moyennes en poids aux masses moléculaires moyennes en nombre, est quant à elle de préférence inférieur à 3 et de façon encore plus préférée inférieur à 2 (bornes comprises).

Le nombre « n » de polymères dans le mélange est de préférence 1<n≤5, et de façon encore préférée 2≤n≤3.

La proportion de chaque polymère utilisé pour réaliser le mélange pourra varier de 0,5 à 99,5% en poids dans le mélange final.

Un tel mélange de polymères permet de réaliser facilement, avec un nombre minimal de polymères, une gamme étendue de compositions permettant de faire varier l'énergie de surface du substrat. Ce mélange permet en outre de moduler très finement et facilement les proportions relatives de chaque polymère constitutif du mélange. Un autre avantage de ce mélange réside dans le fait que l'on peut mélanger des polymères présentant tout ou partie de leurs co-monomères différents des co-monomères à base du copolymère à blocs destiné à être déposé et auto-assemblé sur la surface, de sorte que l'énergie de surface est modulée grâce aux différents co-monomères présents dans le mélange et à leurs proportions relatives dans les différents polymères. De plus, les fonctions chimiques, permettant le greffage des polymères sur le substrat, ainsi que leur nombre et leur position dans les chaines polymères, diffèrent d'un polymère à l'autre. Les différents bouts de chaines des polymères exposés vers la surface permettent alors, eux aussi, de moduler l'énergie de surface.

Il est à noter que la possibilité de mélanger des polymères présentant des co-monomères en partie différents permet d'envisager des fonctionnalisations de surfaces qu'il serait très difficile, voire impossible, de réaliser sans cela. En effet, il est bien connu que certains monomères, de natures chimiques incompatibles, (par exemple un co-monomère A et un co-monomère B) ne peuvent pas être copolymérisés ensembles, sous la forme de copolymères statistiques ou à gradients ou alternés, empêchant donc de « neutraliser » un substrat pour orienter un copolymère à blocs constitué de ces mêmes monomères (A et B). Le fait de copolymériser ces monomères séparément avec un autre co-monomère (respectivement C et D), convenablement choisit, sous forme de copolymères statistiques (A*-stat-*C ; B-*stat*-D) ou à gradients ou alternés, puis d'effectuer un mélange des copolymères ainsi obtenus pour modifier l'énergie de surface d'un substrat permettra alors d'obtenir des surfaces « neutres » par rapport au copolymère à blocs (A-*b*-B).

Dans ce cas, les autres co-monomères (respectivement C et D), copolymérisant avec chacun des co-monomères (respectivement A et B) non copolymérisables ensembles, pourront être identiques ou différents, mais devront être miscibles entre eux.

Cette même approche peut être envisagée avec un mélange de copolymères à blocs (A-*b*-C ; B-*b*-D) si les autres co-monomères (respectivement C et D), copolymérisant avec chacun des co-monomères (respectivement A et B) non copolymérisables ensemble, portent les fonctions chimiques permettant le greffage ou la réticulation de chaque copolymère à blocs sur la surface à neutraliser.

Le mélange doit être réalisé avec des proportions convenablement choisies pour obtenir une neutralisation de la surface. Pour cela on peut s'aider d'abaques permettant de connaitre la relation entre les ratios en co-monomères et l'énergie de surface d'un substrat donné, afin de modifier les proportions de chacun des polymères, de compositions connues, dans le mélange.

Concernant la synthèse des polymères utilisés pour le mélange, ils pourront être synthétisés par toute technique de polymérisation appropriée, telle que par exemple la polymérisation anionique, la polymérisation cationique, la polymérisation radicalaire contrôlée ou non, la polymérisation par ouverture de cycle. Dans ce cas, le ou les différents co-monomères constitutifs de chaque polymère seront choisis dans la liste usuelle des monomères correspondants à la technique de polymérisation choisie.

Lorsque le procédé de polymérisation est conduit par une voie radicalaire contrôlée, qui est la voie préférée utilisée dans l'invention, toute technique de polymérisation radicalaire contrôlée pourra être utilisée, que ce soit la NMP ("Nitroxide Mediated Polymerization"), RAFT ("Reversible Addition and Fragmentation Transfer"), ATRP ("Atom Transfer Radical Polymerization"), INIFERTER ("Initiator-Transfer-Termination"), RITP (" Reverse Iodine Transfer Polymerization"), ITP ("Iodine Transfer Polymerization). De préférence, le procédé de polymérisation par une voie radicalaire contrôlée sera effectué par la NMP.

Plus particulièrement les nitroxides issus des alcoxyamines dérivées du radical libre stable (1) sont préférées. 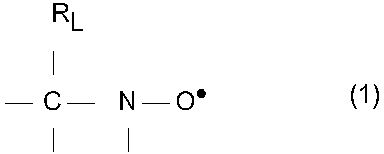 dans laquelle le radical R_{L} présente une masse molaire supérieure à 15,0342 g/mole. Le radical R_{L} peut être un atome d'halogène tel que le chlore, le brome ou l'iode, un groupement hydrocarboné linéaire, ramifié ou cyclique, saturé ou insaturé tel qu'un radical alkyle ou phényle, ou un groupement ester -COOR ou un groupement alcoxyle -OR, ou un groupement phosphonate -PO(OR)₂, dès lors qu'il présente une masse molaire supérieure à 15,0342. Le radical R_{L}, monovalent, est dit en position β par rapport à l'atome d'azote du radical nitroxyde. Les valences restantes de l'atome de carbone et de l'atome d'azote dans la formule (1) peuvent être liées à des radicaux divers tels qu'un atome d'hydrogène, un radical hydrocarboné comme un radical alkyle, aryle ou aryle-alkyle, comprenant de 1 à 10 atomes de carbone. Il n'est pas exclu que l'atome de carbone et l'atome d'azote dans la formule (1) soient reliés entre eux par l'intermédiaire d'un radical bivalent, de façon à former un cycle. De préférence cependant, les valences restantes de l'atome de carbone et de l'atome d'azote de la formule (1) sont liées à des radicaux monovalents. De préférence, le radical R_{L} présente une masse molaire supérieure à 30 g/mole. Le radical R_{L} peut par exemple avoir une masse molaire comprise entre 40 et 450 g/mole. A titre d'exemple, le radical R_{L} peut être un radical comprenant un groupement phosphoryle, ledit radical R_{L} pouvant être représenté par la formule : 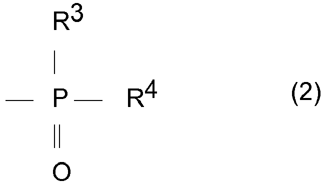 dans laquelle R³ et R⁴, pouvant être identiques ou différents, peuvent être choisis parmi les radicaux alkyle, cycloalkyle, alkoxyle, aryloxyle, aryle, aralkyloxyle, perfluoroalkyle, aralkyle, et peuvent comprendre de 1 à 20 atomes de carbone. R³ et/ou R⁴ peuvent également être un atome d'halogène comme un atome de chlore ou de brome ou de fluor ou d'iode. Le radical R_{L} peut également comprendre au moins un cycle aromatique comme pour le radical phényle ou le radical naphtyle, ce dernier pouvant être substitué, par exemple par un radical alkyle comprenant de 1 à 4 atomes de carbone.

Plus particulièrement les alcoxyamines dérivées des radicaux stables suivants sont préférées :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

De façon préférée, les alcoxyamines dérivées du N-tertiobutyl-1-diéthylphosphono-2,2-diméthyl-propyl nitroxyde seront utilisées.

Les co-monomères constitutifs des polymères synthétisés par voie radicalaire, seront par exemple choisis parmi les monomères suivants : les monomères vinylique, vinylidénique, diénique, oléfinique, allylique ou (méth)acrylique ou cyclique. Ces monomères sont choisis plus particulièrement parmi les monomères vinylaromatiques tels que le styrène ou les styrènes substitués notamment l'alpha-méthylstyrène, les monomères acryliques tels que l'acide acrylique ou ses sels, les acrylates d'alkyle, de cycloalkyle ou d'aryle tels que l'acrylate de méthyle, d'éthyle, de butyle, d'éthylhexyle ou de phényle, les acrylates d'hydroxyalkyle tels que l'acrylate de 2-hydroxyéthyle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxy-polyéthylèneglycol-polypropylèneglycol ou leurs mélanges, les acrylates d'aminoalkyle tels que l'acrylate de 2-(diméthylamino)éthyle (ADAME), les acrylates fluorés, les acrylates silylés, les acrylates phosphorés tels que les acrylates de phosphate d'alkylèneglycol,les acrylates de glycidyle, de dicyclopentenyloxyethyle, les monomères méthacryliques comme l'acide méthacrylique ou ses sels, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'hydroxyalkyle tels que le méthacrylate de 2-hydroxyéthyle ou le méthacrylate de 2-hydroxypropyle, les méthacrylates d'étheralkyle tels que le méthacrylate de 2-éthoxyéthyle, les méthacrylates d'alcoxy- ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxypolyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxy-éthylimidazolidone, le méthacrylate d'hydroxy-éthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'acide itaconique, l'acide maléique ou ses sels, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, le 1, 1-diphényléthylène, l'hexène et le 1-octène, les monomères dièniques dont le butadiène, l'isoprène ainsi que les monomères oléfiniques fluorés, et les monomères vinylidénique, parmi lesquels on peut citer le fluorure de vinylidène, le cas échéants protégés pour être compatible avec les procédés de polymérisation.

Lorsque le procédé de polymérisation est conduit par une voie anionique, on pourra considérer tout mécanisme de polymérisation anionique, que ce soit la polymérisation anionique ligandée ou encore la polymérisation anionique par ouverture de cycle.

De préférence, on utilisera un procédé de polymérisation anionique dans un solvant apolaire, et de préférence le toluène, tel que décrit dans le brevet EP0749987, et mettant en jeu un micro-mélangeur.

Lorsque les polymères sont synthétisés par voie cationique, anionique ou par ouverture de cycle, le ou les co-monomères constitutifs des polymères, seront par exemple choisis parmi les monomères suivants : les monomères vinylique, vinylidénique, diénique, oléfinique, allylique, (méth)acrylique ou cyclique. Ces monomères sont choisis plus particulièrement parmi les monomères vinylaromatiques tels que le styrène ou les styrènes substitués notamment l'alpha-méthylstyrène, les styrènes silylés, les monomères acryliques tels les acrylates d'alkyle, de cycloalkyle ou d'aryle tels que l'acrylate de méthyle, d'éthyle, de butyle, d'éthylhexyle ou de phényle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxy-polyéthylèneglycol-polypropylèneglycol ou leurs mélanges, les acrylates d'aminoalkyle tels que l'acrylate de 2-(diméthylamino)éthyle (ADAME), les acrylates fluorés, les acrylates silylés, les acrylates phosphorés tels que les acrylates de phosphate d'alkylèneglycol,les acrylates de glycidyle, de dicyclopentenyloxyethyle, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'étheralkyle tels que le méthacrylate de 2-éthoxyéthyle, les méthacrylates d'alcoxy- ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxy-polyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxy-éthylimidazolidone, le méthacrylate d'hydroxy-éthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'acide itaconique, l'acide maléique ou ses sels, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, le 1, 1-diphényléthylène, l'hexène et le 1-octène, les monomères dièniques dont le butadiène, l'isoprène ainsi que les monomères oléfiniques fluorés, et les monomères vinylidénique, parmi lesquels on peut citer le fluorure de vinylidène, les monomères cycliques parmi lesquels on peut citer les lactones telle l'e-caprolactone, les lactides , glycolides, les carbonates cycliques tel le triméthylènecarbonate, les siloxanes tel l'octaméthylcyclotetrasiloxane, les éthers cycliques tel le trioxane, les amides cyliques telle l'e-caprolactame, les acétals cycliques tel le 1,3-dioxolane, les phosphazènes tel l'hexachlorocyclotriphosphazéne, les N-carboxyanhydrides, les époxydes, les cyclosiloxanes, les esters cycliques phosphorés tels les cyclophosphorinanes, les cyclophospholanes, les oxazolines, le cas échéants protégés pour être compatible avec les procédés de polymérisation, les méthacrylates globulaires tels que les méthacrylates d'isobornyle, isobornyle halogénés, méthacrylate d'alkyle halogénés, méthacrylate de naphtyle, seuls ou en mélange d'au moins deux monomères précités.

De préférence, le mélange de polymère sera homogène, c'est-à-dire qu'il ne doit pas présenter une ségrégation de phase macroscopique entre les copolymères du mélange. Pour cela, les polymères constitutifs du mélange devront présenter une bonne miscibilité.

Concernant le procédé de contrôle de l'énergie de surface d'un substrat utilisant le mélange de polymères de l'invention, il est applicable à tout substrat, c'est-à-dire à un substrat de nature minérale, métallique ou organique.

Parmi les substrats privilégiés on peut citer les substrats minéraux constitués de silicium ou de germanium présentant une couche d'oxyde natif ou thermique, ou d'oxydes d'aluminium, de cuivre, de nickel, de fer, ou de tungstène par exemple ; les substrats métalliques constitués d'or, de nitrures métalliques tels que le nitrure de titane par exemple, ou les substrats organiques constitués de tétracène, anthracène, polythiophène, PEDOT (poly(3,4-éthylènedioxythiophène)), PSS (poly(styrène sulfonate) de sodium), PEDOT :PSS, fullerène, Polyfluorène, polyéthylènetéréphtalate, polymères réticulés d'une manière générale (tels que les polyimides par exemple), les graphènes, de polymères organiques antireflets BARC (de l'acronyme anglais « Bottom Anti Reflecting Coating ») ou de toute autre couche antireflets utilisée en lithographie. Il est à noter que les substrats organiques devront comporter des fonctions chimiques qui permettent l'ancrage des polymères à greffer sur sa surface.

Le procédé de l'invention consiste plus particulièrement à préparer le mélange de polymères, de compositions connues, dans des proportions convenablement choisies pour permettre une neutralisation de la surface du substrat, puis à déposer le mélange sur la surface du substrat selon des techniques connues de l'homme du métier, comme par exemple la technique dite « spin coating », « docteur Blade » « knife system », « slot die system » par exemple. Le mélange ainsi déposé, sous forme de film sur la surface du substrat, est ensuite soumis à un traitement en vue de permettre le greffage et/ou la réticulation des polymères du mélange sur la surface. Ce traitement peut se faire de différentes manières selon les polymères et les fonctions chimiques qu'ils renferment. Ainsi, le traitement permettant le greffage ou la réticulation de chacun des polymères du mélange sur la surface de substrat, pourra être choisi parmi l'un au moins des traitements suivants : un traitement thermique, encore dénommé recuit, un traitement par oxydo-réduction organique ou inorganique, un traitement électrochimique, un traitement photochimique, un traitement par cisaillement ou un traitement par rayons ionisants. Ce traitement s'effectue à une température < 280°C, de préférence inférieure à 250 dans des temps inférieurs ou égal à 10 minutes et de préférence inférieurs ou égal à 2 minutes.

Un rinçage dans un solvant, tel que l'acétate d'éther monométhylique de propylène glycol (PGMEA) par exemple, permet ensuite d'éliminer les chaines de polymères non greffées ou non réticulées excédentaires. Puis le substrat est séché par exemple sous flux d'azote.

Le mélange de polymères ainsi fixé sur la surface du substrat permet de contrôler son énergie de surface vis-à-vis d'un copolymère à blocs ultérieurement déposé, de manière à obtenir une orientation particulière des nano-domaines du copolymère à blocs par rapport à la surface. Selon une forme préférée mais non limitante de l'invention, les copolymères à blocs déposés sur les surfaces traitées par le procédé de l'invention sont de préférence des copolymères diblocs. Le copolymère à blocs est déposé par toute technique connue de l'homme du métier citée ci-dessus puis soumis à un traitement thermique pour permettre sa nano-structuration en nano-domaines orientés perpendiculairement à la surface.

L'exemple suivant illustre de façon non limitative la portée de l'invention.

### Exemple :

### Synthèse des copolymères statistiques

### 1ere étape: Préparation d'une alcoxyamine fonctionnalisée hydroxy (amorceur) à partir de l'alcoxyamine commerciale BlocBuilder®MA (amorceur 1) :

Dans un ballon de 1L purgé à l'azote, on introduit :
- 226,17 g de BlocBuilder®MA (1 équivalent)
- 68,9 g d'acrylate de 2-hydroxyethyle (1 équivalent)
- 548 g d'isopropanol

Le mélange réactionnel est chauffé à reflux (80°C) pendant 4h puis l'isopropanol est évaporé sous vide. On obtient 297 g d'alcoxyamine fonctionnalisée hydroxy (amorceur) sous la forme d'une huile jaune très visqueuse.

### 2eme étape : Préparation de copolymères Polystyrène / Polyméthacrylate de méthyle.

Dans un réacteur en acier inoxydable équipé d'un agitateur mécanique et d'une double enveloppe, sont introduits le toluène, ainsi que le styrène (S), le méthacrylate de méthyle (MMA), et l'amorceur. Les ratios massiques entre les différents monomères styrène (S), le méthacrylate de méthyle (MMA) sont décrits dans le tableau 1 ci-dessous. La charge massique de toluène est fixée à 30% par rapport au milieu réactionnel. Le mélange réactionnel est agité et dégazé par un bullage d'azote à température ambiante pendant 30 minutes.

La température du milieu réactionnel est alors portée à 115°C Le temps t=0 est déclenché à température ambiante. La température est maintenue à 115°C tout le long de la polymérisation jusqu'à atteindre une conversion des monomères de l'ordre de 70%. Des prélèvements sont réalisés à intervalles réguliers afin de déterminer la cinétique de polymérisation par gravimétrie (mesure d'extrait sec).

Lorsque la conversion de 70% est atteinte, le milieu réactionnel est refroidi à 60°C et le solvant et monomères résiduels sont évaporés sous vide. Après évaporation, la méthyléthylcétone est additionnée au milieu réactionnel en quantité telle que l'on réalise une solution de copolymère de l'ordre de 25% massique.

Cette solution de copolymère est alors introduite goutte à goutte dans un bécher contenant un non-solvant (l'heptane), de manière à faire précipiter le copolymère. Le ratio massique entre solvant et non-solvant (méthyléthylcétone/heptane) est de l'ordre de 1/10. Le copolymère précipité est récupéré sous la forme d'une poudre blanche après filtration et séchage.

### Synthèse d'un copolymère di bloc PS-b-PMMA

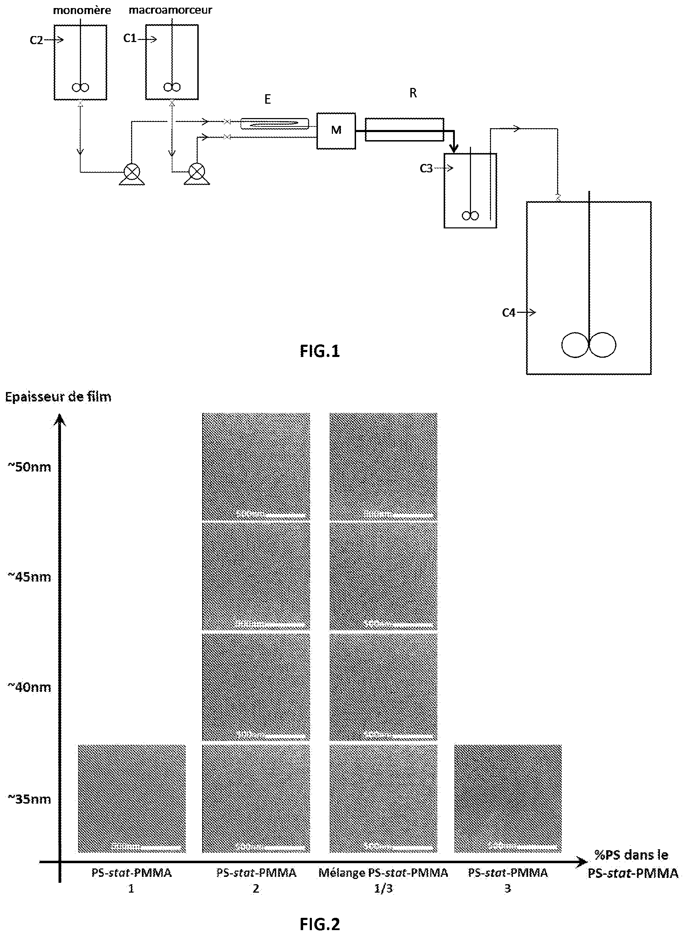

L'installation de la polymérisation utilisée est représentée de façon schématique en Figure 1. Une solution du système macroamorçant est préparée dans une capacité C1 et une solution du monomère dans une capacité C2. Le flux de la capacité C2 est adressé à un échangeur E pour être amené à la température initiale de polymérisation. Les deux flux sont ensuite adressés à un mélangeur M, qui dans cet exemple est un micromélangeur, comme décrit dans la demande de brevet EP0749987, puis au réacteur de polymérisation R qui est un réacteur tubulaire usuel. Le produit est réceptionné dans une capacité C3 qui est ensuite transféré dans une capacité C4 pour y être précipité.

Dans la capacité C1, on prépare une solution à 21.1% massique dans le toluène à 45°C du système macroamorceur poly(styryl)CH₂C(Ph)₂Li/CH₃OCH₂CH₂OLi de rapport molaire 1/6 à 9.8 × 10⁻² mol de poly(styryl)CH₂C(Ph)₂Li comme cela est décrit dans EP0749987 et EP0524054.

Dans la capacité C2, on stocke à -15 °C une solution de MMA passé sur tamis moléculaire à 9% massique dans le toluène.

Le taux de copolymère final visé est de 16.6% massique. La capacité C1 est refroidi à -20 °C et le flux de la solution du système macroamorceur est réglé à 60 kg/h. Le flux de la solution de MMA de la capacité C2 est adressé à un échangeur pour que la température y soit abaissé à -20 °C et le flux de la solution de MMA est réglé à 34.8 kg/h. Les deux flux sont ensuite mélangés dans le mélangeur statistique puis récupéré dans une capacité C3 où le copolymère est désactivé par l'ajout d'une solution de méthanol puis précipité dans une capacité C4 contenant 7 volume de méthanol par volume de mélange réactionnel.

Après séparation puis séchage, les caractéristiques du copolymère à bloc sont les suivantes :
Mn = 56.8 kg/mol
Mw/Mn = 1.10
Ratio massique PS/PMMA = 68.0/32.0

Les mesures sont effectuées par SEC à l'aide d'étalons polystyrene, avec une double détection (réfractométrique et UV), la détection UV permettant de calculer la proportion de PS. A défaut d'utiliser des copolymères à blocs préparés comme dans le présent exemple, l'invention pourra également être réalisée à l'aide d'autres copolymères à blocs d'autre provenance, à condition qu'ils présentent des caractéristiques identiques de masses moléculaires, polymolécularité et ratio massique PS/PMMA.

Dans l'exemple ci-dessous, les copolymères statistiques et le copolymère à bloc utilisés sont à base de polystyrène et de polyméthacrylate de méthyle (abrégés PS-*stat*-PMMA et PS-*b*-PMMA respectivement).

Des surfaces de silicium, orientées suivant la direction cristallographique [1,0,0], sont tout d'abord découpées en morceaux de 3x3cm. Une solution de copolymère statistique, ou de mélange de copolymères, dans de l'acétate d'éther monométhylique de propylène glycol (PGMEA) à hauteur de 2% massique est déposée sur la surface par toute technique connue de l'homme du métier (spin-coating, doctor-blade, drop-casting...), puis évaporée de manière à laisser un film sec de copolymère sur le substrat. Les différentes solutions de copolymère statistique ou de mélange de copolymères qui sont comparées dans cet exemple, sont rassemblées dans le tableau I ci-dessous. Le substrat est alors recuit à 230°C durant 10 minutes afin de greffer les chaines de copolymère sur la surface, puis le substrat est alors rincé dans le PGMEA pur pour éliminer les chaines de polymère non-greffées excédentaires. La solution de copolymère à blocs, dissout à hauteur de 1 à 1,5% massique dans le PGMEA, est ensuite déposée sur la surface fraichement fonctionnalisée puis évaporée de manière à obtenir un film sec de copolymère à blocs d'épaisseur désirée. Le substrat est alors recuit à 230°C durant 5 minutes de façon à promouvoir l'auto-organisation du copolymère à blocs sur la surface. Les surfaces ainsi organisées sont par la suite trempées dans l'acide acétique durant quelques minutes puis rincées à l'eau déionisée de manière à augmenter le contraste entre les deux blocs du copolymère à blocs lors de l'imagerie par microscopie électronique à balayage.

La Figure 2 représente des photos, prises au microscope électronique à balayage (MEB), de plusieurs échantillons d'un film de copolymère à blocs auto-assemblé, d'épaisseurs comprises entre 35 et 50nm, le film de copolymère à blocs étant déposé sur des surfaces de silicium fonctionnalisées avec les différentes solutions de copolymères ou mélanges de copolymères du tableau I ci-dessous.

**Tableau I**

| | **Synthèse** | **Caractérisations produit final** | | |
|---|---|---|---|---|
| **Polymère** | **% massique amorceur par rapport aux monomères** | **%styrène** | **%méthacrylate de méthyle** | **Mn (kg/mol)** |
| PS-*stat*-PMMA 1 | 3.37 | 58 | 42 | 14.0 |
| PS-*stat*-PMMA2 | 3.36 | 69 | 31 | 13.7 |
| PS-*stat*-PMMA3 | 3.35 | 85 | 15 | 13.7 |
| Mélange (PS-*stat*-PMMA1 + PS-*stat*-PMMA3) | / | 70 | 30 | / |

La Figure 2 montre l'assemblage d'un copolymère à blocs cylindrique PS-b-PMMA (cylindres de PMMA dans une matrice de PS) pour différentes épaisseurs de film, de période de l'ordre de 32nm, obtenu sur des surfaces fonctionnalisées avec trois copolymères statistiques purs de compositions différentes (PS-*stat*-PMMA1, *PS-stat-*PMMA2, et PS-*stat*-PMMA3), et également avec des surfaces fonctionnalisées avec un mélange de copolymères statistiques PS-*stat*-PMMA1 et PS-*stat*-PMMA3, dont la composition finale correspond à celle du copolymère statique PS-*stat*-PMMA2. Les photos MEB des films d'épaisseur 35nm montrent que la composition du copolymère statistique greffé doit être finement contrôlée si on souhaite orienter correctement les cylindres du copolymère à blocs. Une orientation parallèle ou bien mixte parallèle/perpendiculaire des cylindres est en effet observée lorsque les copolymères statistiques PS-*stat*-PMMA1 et PS-*stat*-PMMA3 sont utilisés respectivement, alors qu'une orientation perpendiculaire est obtenue lorsque le copolymère PS-*stat*-PMMA2 est greffé sur la surface. On constate aussi qu'une orientation perpendiculaire est obtenue, pour la même épaisseur de film, lorsqu'un simple mélange de copolymère statistique PS-*stat*-PMMA1 et PS-*stat*-PMMA3 de composition finale ciblée est utilisé pour fonctionnaliser la surface, démontrant ainsi l'efficacité de la présente invention. On démontre par ailleurs que le mélange de PS-*stat*-PMMA1 et PS-*stat*-PMMA3 présente les mêmes propriétés que le copolymère PS-*stat*-PMMA2, puisqu'une orientation perpendiculaire des cylindres du copolymère à blocs est obtenue pour des épaisseurs de films comparables et plus importantes, aussi bien lorsque le copolymère statistique pur PS-*stat*-PMMA2 que lorsque le mélange de PS-*stat*-PMMA1 et *PS-stat-*PMMA3, est employé.

## Revendications

1. Procédé de nano-structuration d'un copolymère à blocs **caractérisé en ce qu'**il comprend les étapes d'un procédé de contrôle de l'énergie de surface d'un substrat, permettant l'obtention d'une orientation particulière des nano-domaines du film de copolymère à blocs déposé ultérieurement sur ladite surface, puis une étape de dépôt d'une solution du copolymère à blocs sur la surface dudit substrat préalablement traitée, et une étape de recuit permettant une nano-structuration dudit copolymère à blocs par génération de motifs nano-structurés et orientés selon une direction particulière, ledit procédé de contrôle de l'énergie de surface d'un substrat étant **caractérisé en ce qu'**il comprend les étapes suivantes :
- préparer un mélange de copolymères, chaque copolymère comprenant au moins une fonction permettant son greffage ou sa réticulation sur la surface dudit substrat,
- déposer ledit mélange ainsi préparé sur la surface dudit substrat,
- procéder à un traitement entraînant le greffage ou la réticulation de chacun des copolymères du mélange sur la surface du substrat.

2. Procédé selon la revendication 1, dans lequel le traitement entrainant le greffage ou la réticulation est effectué à une température inférieure à 280 °C dans un temps inférieur ou égal à 10 minutes.

3. Procédé selon l'une des revendications 1 à 2, **caractérisé en ce que** l'étape de greffage ou de réticulation de chacun des copolymères du mélange est réalisée par l'un au moins des traitements suivants : traitement thermique, traitement par oxydo-réduction organique ou inorganique, traitement électrochimique, traitement photochimique, traitement par cisaillement ou traitement par rayons ionisants.

4. Procédé selon l'une des revendications 1 à 3, **caractérisé en ce que** le nombre n de copolymères dans le mélange est tel qu'il est 1<n≤5, et de préférence 2≤n≤3.

5. Procédé selon l'une des revendications 1 à 4, **caractérisé en ce que** les copolymères constitutifs du mélange sont des copolymères statistiques et/ou à gradients et/ou à blocs et/ou alternés.

6. Procédé selon l'une des revendications 1 à 5, **caractérisé en ce que** les proportions de chaque copolymère dans le mélange sont comprises entre 0,5 et 99,5% en poids du mélange final.

7. Procédé selon l'une des revendications précédentes, **caractérisé en ce que** chaque copolymère du mélange comprend un nombre x variable de co-monomères, avec x prenant des valeurs entières de préférence x≤7, et de manière encore plus préférée 2≤x≤5.

8. Procédé selon l'une des revendications précédentes, **caractérisé en ce que** les proportions relatives, en unités monomères, de chaque co-monomère constitutif de chaque copolymère du mélange sont comprises entre 1 et 99% par rapport au(x) co-monomère(s) avec le(s)quel(s) il copolymérise.

9. Procédé selon l'une des revendications précédentes, **caractérisé en ce que** la masse moléculaire en nombre de chaque polymère du mélange est de préférence comprise entre 500 et 250000 g/mol, et de manière encore plus préférée comprise entre 1000 et 150000 g/mol.

10. Procédé selon l'une des revendications précédentes, **caractérisé en ce que** l'indice de polydispersité de chaque polymère du mélange est de préférence inférieur à 3 et, de manière encore plus préférée, inférieur à 2.

11. Procédé selon l'une des revendications précédentes, **caractérisé en ce que** le mélange comprend des copolymères à blocs, dont au moins un des co-monomères de chaque copolymère à blocs porte les fonctions chimiques permettant le greffage ou la réticulation du copolymère sur la surface du substrat.

12. Procédé selon l'une des revendications précédentes, **caractérisé en ce que** le mélange de copolymères peut en outre comprendre un ou plusieurs homopolymères comprenant au moins une fonction permettant son greffage ou sa réticulation sur la surface dudit substrat.

13. Procédé selon l'une des revendications précédentes, **caractérisé en ce que** le substrat est choisi parmi l'un des substrats suivants : un substrat minéral, un substrat métallique ou un substrat organique.

14. Procédé selon la revendication 13, **caractérisé en ce que** le substrat est minéral il est choisi parmi les substrats constitués de silicium ou de germanium présentant une couche d'oxyde natif ou thermique, ou d'oxydes d'aluminium, de cuivre, de nickel, de fer, ou de tungstène.

15. Procédé selon la revendication 13, **caractérisé en ce que** lorsque le substrat est métallique, choisi parmi les substrats constitués d'or ou de nitrures métalliques.

16. Procédé selon la revendication 13, **caractérisé en ce que** le substrat est organique, choisi parmi les substrats constitués de tétracène, anthracène, polythiophène, PEDOT (poly(3,4-éthylènedioxythiophène)), PSS (poly(styrène sulfonate) de sodium), PEDOT :PSS, fullerène, Polyfluorène, polyéthylènetéréphtalate, polymères réticulés, graphènes, polymères organiques antireflets.

17. Utilisation du procédé de nano-structuration d'un copolymère à blocs selon l'une des revendications 1 à 16 dans des applications de lithographie.

## Patentansprüche

1. Verfahren zur Nanostrukturierung eines Blockcopolymers, **dadurch gekennzeichnet, dass** es die Schritte eines Verfahrens zur Steuerung der Oberflächenenergie eines Substrats, das den Erhalt einer speziellen Orientierung der Nanodomänen des anschließend auf die Oberfläche aufgebrachten Blockcopolymerfilms ermöglicht, dann einen Schritt der Abscheidung einer Lösung des Blockcopolymers auf der Oberfläche des vorbehandelten Substrats und einen Temperschritt, der eine Nanostrukturierung des Blockcopolymers durch Erzeugung von nanostrukturierten und in einer speziellen Richtung orientierten Mustern umfasst, wobei das Verfahren zur Steuerung der Oberflächenenergie eines Substrats **dadurch gekennzeichnet ist, dass** es die folgenden Schritte umfasst:
- Herstellen einer Mischung von Copolymeren, wobei jedes Copolymer mindestens eine Funktion, die dessen Pfropfung oder Vernetzung auf der Oberfläche des Substrats ermöglicht, umfasst,
- Abscheiden der so hergestellten Mischung auf der Oberfläche des Substrats,
- Durchführen einer Behandlung, die zur Pfropfung oder Vernetzung jedes der Copolymere der Mischung auf der Oberfläche des Substrats führt.

2. Verfahren nach Anspruch 1, bei dem die Behandlung, die zur Pfropfung oder Vernetzung führt, bei einer Temperatur von weniger als 280 °C in einem Zeitraum kleiner oder gleich 10 Minuten durchgeführt wird.

3. Verfahren nach einem der Ansprüche 1 bis 2, **dadurch gekennzeichnet, dass** der Schritt der Pfropfung oder Vernetzung jedes der Copolymere der Mischung durch mindestens eine der folgenden Behandlungen durchgeführt wird: Wärmebehandlung, Behandlung durch organische oder anorganische Oxidation-Reduktion, elektrochemische Behandlung, photochemische Behandlung, Behandlung durch Scherung oder Behandlung mit ionisierenden Strahlen.

4. Verfahren nach einem der Ansprüche 1 bis 3, **dadurch gekennzeichnet, dass** die Zahl n von Copolymeren in der Mischung derart beschaffen ist, dass 1 < n ≤ 5 und vorzugsweise 2 ≤ n ≤ 3.

5. Verfahren nach einem der Ansprüche 1 bis 4, **dadurch gekennzeichnet, dass** es sich bei den Aufbaucopolymeren der Mischung um statistische und/oder gradientenartige und/oder blockartige und/oder alternierende Copolymere handelt.

6. Verfahren nach einem der Ansprüche 1 bis 5, **dadurch gekennzeichnet, dass** die Anteile jedes Copolymers in der Mischung zwischen 0,5 und 99,5 Gew.-% der fertigen Mischung liegen.

7. Verfahren nach einem der vorhergehenden Ansprüche, **dadurch gekennzeichnet, dass** jedes Copolymer der Mischung eine variable Zahl x von Comonomeren umfasst, wobei x ganzzahlige Werte annimmt, vorzugsweise x ≤ 7 und noch weiter bevorzugt 2 ≤ x ≤ 5.

8. Verfahren nach einem der vorhergehenden Ansprüche, **dadurch gekennzeichnet, dass** die relativen Monomereinheiten-Anteile jedes Aufbaucomonomers jedes Copolymers der Mischung zwischen 1 und 99 %, bezogen auf das bzw. die Comonomere, mit dem bzw. denen es copolymerisiert, liegen.

9. Verfahren nach einem der vorhergehenden Ansprüche, **dadurch gekennzeichnet, dass** die zahlenmittlere Molmasse jedes Polymers der Mischung vorzugsweise zwischen 500 und 250.000 g/mol und noch weiter bevorzugt zwischen 1000 und 150.000 g/mol liegt.

10. Verfahren nach einem der vorhergehenden Ansprüche, **dadurch gekennzeichnet, dass** der Polydispersitätsindex jedes Polymers der Mischung vorzugsweise kleiner als 3 und noch weiter bevorzugt kleiner als 2 ist.

11. Verfahren nach einem der vorhergehenden Ansprüche, **dadurch gekennzeichnet, dass** die Mischung Blockcopolymere umfasst, wobei mindestens eines der Comonomere jedes Blockcopolymers die chemischen Funktionen, die die Pfropfung oder Vernetzung des Copolymers auf der Oberfläche des Substrats ermöglichen, trägt.

12. Verfahren nach einem der vorhergehenden Ansprüche, **dadurch gekennzeichnet, dass** die Mischung von Copolymeren zusätzlich ein oder mehrere Homopolymere mit mindestens einer Funktion, die dessen Pfropfung oder Vernetzung auf der Oberfläche des Substrats ermöglicht, umfassen kann.

13. Verfahren nach einem der vorhergehenden Ansprüche, **dadurch gekennzeichnet, dass** es sich bei dem Substrat um eines der folgenden Substrate handelt: ein anorganisches Substrat, ein metallisches Substrat oder ein organisches Substrat.

14. Verfahren nach Anspruch 13, **dadurch gekennzeichnet, dass** wenn das Substrat anorganisch ist, es aus Substraten aus Silicium oder Germanium mit einer Schicht aus nativem oder thermischem Oxid oder Aluminium-, Kupfer-, Nickel-, Eisen- oder Wolframoxiden ausgewählt wird.

15. Verfahren nach Anspruch 13, **dadurch gekennzeichnet, dass** das Substrat dann, wenn es metallisch ist, es aus Substraten aus Gold oder Metallnitriden ausgewählt wird.

16. Verfahren nach Anspruch 13, **dadurch gekennzeichnet, dass** das Substrat organisch ist, aus Substraten aus Tetracen, Anthracen, Polythiophen, PEDOT (Poly(3,4-ethylendioxythiophen)), PSS (Natrium(poly(styrolsulfonat)), PEDOT:PSS, Fulleren, Polyfluoren, Polyethylenterephthalat, vernetzten Polymeren, Graphenen, antireflektierenden organischen Polymeren ausgewählt.

17. Verwendung des Verfahrens zur Nanostrukturierung eines Blockcopolymers nach einem der Ansprüche 1 bis 16 bei Lithographieanwendungen.

## Claims

1. Process for nanostructuring a block copolymer, **characterized in that** it comprises the stages of a process for controlling the surface energy of a substrate, making it possible to obtain a specific orientation of the nanodomains of the film of block copolymer subsequently deposited on the said surface, then a stage of depositing a solution of the block copolymer on the surface of the said pretreated substrate and an annealing stage which makes possible nanostructuring of the said block copolymer by generation of nanostructured patterns oriented along a specific direction, the said process for controlling the surface energy of a substrate being **characterized in that** it comprises the following stages:
- preparing a blend of copolymers, each copolymer comprising at least one functional group which allows it to be grafted to or crosslinked on the surface of the said substrate,
- depositing the said blend thus prepared on the surface of the said substrate,
- carrying out a treatment which results in the grafting to the surface of the substrate or the crosslinking on the surface of the substrate of each of the copolymers of the blend.

2. Process according to Claim 1, in which the treatment resulting in the grafting or the crosslinking is carried out at a temperature of less than 280°C in a time of less than or equal to 10 minutes.

3. Process according to either of Claims 1 and 2, **characterized in that** the stage of grafting or crosslinking each of the copolymers of the blend is carried out by at least one of the following treatments: heat treatment, organic or inorganic oxidation/reduction treatment, electrochemical treatment, photochemical treatment, treatment by shearing or treatment with ionizing rays.

4. Process according to one of Claims 1 to 3, **characterized in that** the number n of copolymers in the blend is such that it is 1<n≤5 and preferably 2≤n≤3.

5. Process according to one of Claims 1 to 4, **characterized in that** the constituent copolymers of the blend are statistical and/or gradient and/or block and/or alternating copolymers.

6. Process according to one of Claims 1 to 5, **characterized in that** the proportions of each copolymer in the blend are between 0.5% and 99.5% by weight of the final blend.

7. Process according to one of the preceding claims, **characterized in that** each copolymer of the blend comprises a variable number x of comonomers, with x taking whole values, preferably x≤7, and more preferably still 2≤x≤5.

8. Process according to one of the preceding claims, **characterized in that** the relative proportions, in monomer units, of each constituent comonomer of each copolymer of the blend are between 1% and 99%, with respect to the comonomer(s) with which it copolymerizes.

9. Process according to one of the preceding claims, **characterized in that** the number-average molecular weight of each polymer of the blend is preferably between 500 and 250 000 g/mol and more preferably still between 1000 and 150 000 g/mol.

10. Process according to one of the preceding claims, **characterized in that** the polydispersity index of each polymer of the blend is preferably less than 3 and more preferably still less than 2.

11. Process according to one of the preceding claims, **characterized in that** the blend comprises block copolymers, at least one of the comonomers of each block copolymer of which carries the chemical functional groups which make it possible for the copolymer to be grafted to or crosslinked on the surface of the substrate.

12. Process according to one of the preceding claims, **characterized in that** the blend of copolymers can additionally comprise one or more homopolymers comprising at least one functional group which makes it possible to graft it to or to crosslink it on the surface of the said substrate.

13. Process according to one of the preceding claims, **characterized in that** the substrate is chosen from one of the following substrates: an inorganic substrate, a metallic substrate or an organic substrate.

14. Process according to Claim 13, **characterized in that** if the substrate is inorganic, it is chosen from substrates composed of silicon or germanium exhibiting a layer of native or thermal oxide, or of aluminium, copper, nickel, iron or tungsten oxides.

15. Process according to Claim 13, **characterized in that**, when the substrate is metallic, it is chosen from substrates composed of gold or of metal nitrides.

16. Process according to Claim 13, **characterized in that** the substrate is organic, chosen from substrates composed of tetracene, anthracene, polythiophene, PEDOT (poly(3,4-ethylenedioxythiophene)), PSS (sodium poly(styrene sulphonate)), PEDOT:PSS, fullerene, polyfluorene, polyethylene terephthalate, crosslinked polymers, graphenes or anti-reflecting organic polymers.

17. Use of the process for nanostructuring a block copolymer according to one of Claims 1 to 16 in lithography applications.
